# FASCICULE DE BREVET EUROPEEN

(11) **EP 3 157 050 B1**
(45) Date de publication et mention de la délivrance du brevet: **22.12.2021**
(21) Numéro de dépôt: 16193575.4
(22) Date de dépôt: 12.10.2016
(51) Int. Cl.: H01L 23/04, H01L 23/10, H01M 50/172

(54) **PROCÉDÉ DE RÉALISATION D'UN DISPOSITIF MICROÉLECTRONIQUE ET DISPOSITIF MICROÉLECTRONIQUE AINSI FABRIQUÉ**
HERSTELLUNGSVERFAHREN EINER MIKROELEKTRONISCHEN VORRICHTUNG UND DADURCH HERGESTELLTE MIKROELEKTRONISCHE VORRICHTUNG
METHOD FOR PRODUCING A MICROELECTRONIC DEVICE AND MICROELECTRONIC DEVICE MANUFACTURED THEREBY

(30) Priorité: 15.10.2015 FR 1559794
(43) Date de publication de la demande: 19.04.2017
(73) Titulaire: COMMISSARIAT À L'ÉNERGIE ATOMIQUE ET AUX ÉNERGIES ALTERNATIVES, 75015 Paris (FR)
(72) Inventeur: BEDJAOUI, Messaoud, 38340 VOREPPE (FR); SALOT, Raphaël, 38250 LANS-EN-VERCORS (FR)
(74) Mandataire: Decobert, Jean-Pascal

(56) Documents cités:
- US-A1- 2004 010 910
- US-A1- 2006 063 462
- US-A1- 2006 216 589
- US-A1- 2010 096 712
- US-A1- 2013 061 674
- US-A1- 2015 115 376
- None

## Description

### DOMAINE DE L'INVENTION

La présente invention concerne l'encapsulation et l'intégration de dispositifs notamment microélectroniques comprenant des couches sensibles à l'air. L'invention trouve en particulier son application dans l'assemblage tridimensionnel (3D) des dispositifs électroniques avec des fonctionnalités diverses (mécanique, optique, optoélectronique, etc.).

### ARRIERE-PLAN TECHNOLOGIQUE

Dans certaines applications, notamment dans le domaine de l'électronique, il existe un besoin de fournir des circuits toujours plus performants, tout en étant de moins en moins encombrants. On tend à satisfaire ce besoin en prévoyant des dispositifs et des circuits électroniques basés sur des architectures de « packaging » novatrices, associées à des technologies d'empilement et d'assemblage de composants et d'interconnexions électriques. La motivation principale résulte d'un choix de construction du « packaging » qui veut atteindre une performance électrique maximale, accompagnée d'un encombrement réduit.

D'une manière générale, les composants microélectroniques en couches minces constituent aujourd'hui encore la tête de pont du développement de l'électronique. Parmi les dispositifs les plus étudiés, on trouve les systèmes de stockage d'énergie comme les micro-batteries à base de lithium, les systèmes de récupération d'énergie comme les cellules photovoltaïques organiques et les photodétecteurs organiques ou, encore, les systèmes d'affichage comme les diodes électroluminescentes organiques.

Le problème commun de ces circuits et des couches actives qui les composent, réside en leur dégradation rapide en présence des gaz oxydants de l'atmosphère, eau et oxygène. Ces composants électroniques, dans leur grande majorité, embarquent des solutions d'encapsulation afin de se prémunir des éléments oxydants et corrosifs présents dans l'atmosphère environnante. Sur le plan des performances barrières, les requis peuvent varier d'une application à une autre. Cependant, il est fréquemment admis que le niveau global recherché soit compris entre 10⁻⁴ et 10⁻⁶ g.m⁻².j⁻¹ pour le critère de transmission de la vapeur d'eau (ou acronyme « WVTR » en anglais pour « Water Vapor Transmission Rate ») et entre 10⁻⁴ et 10⁻⁶ cm⁻³.m⁻².j⁻¹ pour le critère de transmission de l'oxygène (acronyme « OTR » en anglais pour « Oxygen Transmission Rate »).

Les solutions d'encapsulation relatées par l'état de l'art antérieur peuvent être réparties en deux familles : produit encapsulant et boitier rapporté. On entend par produit encapsulant, un système barrière étanche réalisé de façon monolithique sur l'empilement des couches actives d'un dispositif microélectronique. Cette solution fait référence aux structures multicouches hybrides alternant des couches minces organiques avec des couches minces inorganiques déposées par des technologies standard de dépôts sous vide. Le principe d'une encapsulation par boitier rapporté est généralement basé sur la réalisation d'une cavité étanche dont l'atmosphère est contrôlée (vide, pression, gaz). Cette encapsulation, dite hétérogène, est considérée comme l'une des solutions les plus fiables pour répondre aux besoins des dispositifs microélectroniques sensibles à l'air. Les principales motivations de ce mode d'encapsulation résident essentiellement dans sa facilité de mise en oeuvre, son faible coût et ses performances (barrière, mécanique, adhérence, thermique), en comparaison aux solutions d'encapsulation monolithiques. Dans cette technologie, le système d'encapsulation peut être réalisé séparément avant de le reporter sur le support contenant les couches actives formant le dispositif microélectronique. Ainsi, la cavité étanche peut être définie, par exemple, par un capot reporté et scellé sur un substrat contenant des couches actives sensibles à l'air. Ces solutions de report de capot s'adaptent parfaitement aux exigences d'intégration des dispositifs microélectroniques grâce notamment à leur capacité à réduire leurs dimensions de longueur, de largeur et d'épaisseur.
Qu'elles soient monolithiques ou hétérogènes, la première fonction des solutions d'encapsulation est de protéger le dispositif microélectronique de l'environnement externe. Toutefois, ces solutions doivent aussi offrir une intégration aisée par un accès direct aux plots d'entrée/sortie des composants.

Pour pallier cet inconvénient, il a été proposé d'utiliser les technologies de « vias traversants » usinés dans l'un des substrats comme décrit dans EP A1 1557394, le plus souvent dans les capots pour accéder aux contacts électriques. Cependant se pose alors le problème d'étanchéité et d'herméticité des vias constitués par rapport aux éléments oxydants. Dans ce cas de figure, la vulnérabilité des solutions d'encapsulation par capot est exclusivement dépendante des passages créés dans le capot ou dans le substrat d'accueil. Le raccordement électrique en vue d'une reprise de contact est aussi perfectible.

Un objet de la présente invention est de prévoir un procédé de réalisation et un système d'encapsulation palliant au moins en partie certains des inconvénients des procédés existants.

On connaît par ailleurs de la publication brevet US 2006/216589 A1 une batterie qui comprend un empilement de deux substrats, avec un joint en périphérie, la batterie comprenant sur une première face au moins un composant électronique doté d'au moins un connecteur électrique, le système comprenant: un capot positionné au-dessus du composant; ledit capot comportant au moins un passage suivant une dimension en épaisseur du capot de sorte à former un accès à l'au moins un connecteur électrique, un cordon de scellement configuré de sorte que le composant soit au moins en partie situé dans une cavité délimitée par la première face du support, la première face du capot et le cordon de scellement, le cordon de scellement comportant un premier cordon, le premier cordon s'étendant autour de l'au moins un passage en un contour fermé formant une paroi pleine et continue délimitant latéralement un espace débouchant au travers de l'au moins un passage; le système comportant un matériau électriquement conducteur remplissant l'espace débouchant au travers de l'au moins un passage du capot de sorte à établir une continuité électrique entre le matériau électriquement conducteur et l'au moins un connecteur électrique, le matériau électriquement conducteur formant une reprise de contact, le cordon de scellement étant diélectrique.

Pour réaliser des raccordements électriques, dans un mode de réalisation, des connecteurs électriques sous forme de piliers sont insérés, en traversant le joint.

On connaît en outre de la publication US 2015/115376 A1 un dispositif comprenant une chambre hermétique formée entre deux substrats en vis-à-vis et isolée avec des joints périphériques, le dispositif comprenant sur une première face au moins un composant électronique doté d'au moins un connecteur électrique, le système comprenant: - un capot positionné au-dessus du composant ; ledit capot comportant au moins un passage suivant une dimension en épaisseur du capot de sorte à former un accès à l'au moins un connecteur électrique, un cordon de scellement configuré de sorte que le composant soit au moins en partie situé dans une cavité délimitée par la première face du support, la première face du capot et le cordon de scellement, le cordon de scellement comportant un premier cordon, le premier cordon s'étendant autour de l'au moins un passage en un contour fermé formant une paroi pleine et continue délimitant latéralement un espace débouchant au travers de l'au moins un passage; le système comportant un matériau électriquement conducteur remplissant l'espace débouchant au travers de l'au moins un passage du capot de sorte à établir une continuité électrique entre le matériau électriquement conducteur et l'au moins un connecteur électrique, le matériau électriquement conducteur formant une reprise de contact, le cordon de scellement étant diélectrique.

### RESUME DE L'INVENTION

Un aspect de la présente invention concerne un procédé de réalisation d'un système électrique selon la revendication 1.

La présence invention concerne également un système selon la revendication 12.

Le cordon de scellement comporte un premier cordon dans la dimension longitudinale forme un contour fermé autour du passage. De préférence, ce premier cordon s'étend uniquement autour de ce passage de sorte à isoler de façon spécifique l'espace intérieur de la cavité située au droit du passage. Avantageusement, le connecteur est disposé de sorte que la projection du passage suivant l'épaisseur du support intersecte uniquement le connecteur de sorte que le premier cordon assure l'étanchéité de la portion considérée du connecteur qui est en regard du passage relativement au reste du composant électronique et éventuellement au reste du connecteur si le premier cordon de scellement isole qu'une partie de ce dernier.

Ainsi, le raccordement électrique pour la reprise de contact au niveau d'un connecteur s'opère sans remettre en cause l'étanchéité. Le cordon de scellement produit une paroi permettant d'isoler le matériau électriquement conducteur.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1 illustre une vue de dessus d'un composant, par exemple une batterie unitaire, comprenant un premier connecteur électrique et un deuxième connecteur électrique.
- La FIGURE 2 illustre une vue en coupe selon la ligne AA de la figure 1 d'un composant sur une première face d'un support formant, par exemple, une batterie unitaire.
- La FIGURE 3 illustre un capot doté d'un premier passage et d'un deuxième passage, suivant une dimension en épaisseur du capot.
- La FIGURE 4 illustre la formation d'un cordon de scellement sur une première face du capot. La FIGURE 4bis en présente une variante quant à la forme du cordon de scellement.
- La FIGURE 5 illustre, dans le cas de la figure 4, la mise en place du capot, ledit capot se positionnant sur le composant de sorte que le cordon de scellement joigne la première face du capot et le composant formé sur la première face du support.
- La FIGURE 6 illustre une vue en coupe selon la ligne BB de la figure 5 d'un composant encapsulé dans une cavité étanche délimitée par la première face du support, la première face du capot et le cordon de scellement.
- La FIGURE 7 illustre une vue en coupe de l'étape de remplissage des passages du capot par un matériau conducteur.
- La FIGURE 8 illustre un exemple de réalisation particulier où le composant, par exemple une batterie, comprend deux ouvertures qui traversent les connecteurs électriques 21, 22 du composant 2.
- La FIGURE 9 illustre un exemple de réalisation particulier où le cordon de scellement est formé sur la première face du support.
- La FIGURE 10 illustre une vue en coupe d'un exemple de réalisation particulier comprenant une pluralité de dispositifs empilés.
- La FIGURE 11 illustre une vue en coupe d'un exemple de réalisation particulier où les dispositifs sont empilés et coopèrent afin de former des vias traversants.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- préalablement à l'étape de remplissage par un matériau électriquement conducteur, on réalise dans le support (1) l'au moins un passage (63, 64) suivant une dimension en épaisseur dudit support de sorte à ce que l'au moins un passage (63, 64) traverse l'au moins un connecteur électrique (21, 22) ;
- l'étape de remplissage est configurée de sorte à ce que le matériau conducteur traverse le support (1) au travers de l'au moins un passage (63, 64) de sorte à être exposé au niveau d'une deuxième face du support (1), opposée à la première face.
- le connecteur (21, 22) est positionné en périphérie du composant électronique (2).
- l'étape de mise en place du capot (6) est configurée pour préserver au moins un deuxième accès à au moins un deuxième connecteur électrique (61, 62) ; ledit capot (6) comportant au moins un deuxième passage (61, 62) suivant une dimension en épaisseur du capot (6), et l'étape de remplissage par un matériau conducteur est réalisée de sorte à remplir au moins le premier passage (61) formant une première reprise de contact (81) en continuité électrique avec le premier connecteur électrique (21) et le deuxième passage (62) formant une deuxième reprise de contact (82) en continuité électrique avec le deuxième connecteur électrique (22).
- le capot (6) comprend au moins un composant électronique (2) sur au moins l'une de ses faces et dans lequel l'au moins un passage (61, 62) du capot (6) traverse l'au moins un connecteur électrique (21, 22) du composant de sorte à ce que l'étape de remplissage soit configurée de sorte à établir une continuité électrique entre l'au moins un connecteur électrique (21, 22) d'un composant électronique (2) porté par le support (1) et l'au moins un connecteur électrique (21, 22) du composant électronique (2) porté par le capot (6).
- on superpose plusieurs dispositifs suivant la dimension en épaisseur, le capot (6) d'un premier dispositif faisant office de support (1) pour un deuxième dispositif, de sorte à ce que, lors de l'étape de remplissage, l'au moins un connecteur électrique (21, 22) de chacun des dispositifs soit mis en continuité électrique entre eux par le matériau conducteur de sorte à former une reprise de contact (81, 82) du système commune auxdits dispositifs.
- au moins un passage (61, 62) de chaque dispositif est en regard d'un passage (61, 62) de chacun des autres dispositifs.
- le cordon de scellement (7) comprend un deuxième cordon (72) ; le deuxième cordon (72) formant un contour fermé ou non autour d'au moins une partie du composant, une portion de l'au moins un connecteur électrique (21, 22) n'étant pas entouré par ledit deuxième cordon (72). De préférence, une portion de l'au moins un connecteur électrique (21, 22) n'est pas entourée par ledit deuxième cordon (72) ; de préférence, le deuxième cordon est utilisé en conjonction avec le premier cordon de sorte que chacun des deux cordons est spécifiquement dédié à l'isolation de parties différentes du composant électronique. Cela n'exclut pas que ces deux cordons aient des parties communes ou se rejoignent à certains endroits.
- Le cordon de scellement est formé avec un dépôt de matière sur une face du support et/ou du capot ;
- après l'étape de mise en place du capot (6), le cordon de scellement étant en matériau fusible, on effectue un traitement thermique dudit cordon. Le traitement thermique peut comprendre un traitement local par exemple par irradiation laser du cordon de scellement (7) au travers du capot (6) et/ou du substrat (1), ou un traitement thermique global du .système. D'une manière générale, on peut avoir recours à un chauffage localisé ; il est aussi possible d'employer la thermocompression, en particulier pour les composants peu sensibles à la température ;
- le cordon de scellement est en matériau fusible ;
- après l'étape de formation du composant électronique (2), on dépose une couche de scellement sur toute la surface de la première face du capot (6) et/ou de la première face du substrat (1) et, après la mise en place du capot (6), on effectue un traitement thermique local par une irradiation laser de ladite couche de scellement de sorte à former le cordon de scellement (7).
- l'étape de mise en place du capot (6) comprend une étape de compression du cordon de scellement (7).
- le cordon de scellement (7) comprend un matériau compressible dont le module d'élasticité est compris entre 50 et 80 GPa (gigaPascal). Il peut s'agir de pâte de verre. En complément ou alternativement, le coefficient CET (coefficient d'expansion thermique) du cordon peut être compris entre 10⁻⁷ °C et 10⁻⁵ °C ;
- le support (1) et/ou le capot (6) sont/est formé(s) en un matériau à base de verre et/ou transparent.
- le support (1) comprend au moins un passage (63, 64) suivant une dimension en épaisseur dudit support (1) de sorte à ce que l'au moins un passage (63, 64) traverse l'au moins un connecteur électrique (21, 22).
- le matériau conducteur traverse le support (1) au travers de l'au moins un passage (63, 64) de sorte à être exposé au niveau d'une deuxième face du support (1), opposée à la première face.
- le connecteur (21, 22) est positionné en périphérie du composant électronique (2).
- le capot (6) comprend au moins un composant électronique (2) sur au moins l'une de ses faces et dans lequel l'au moins un passage (61, 62) du capot (6) traverse l'au moins un connecteur électrique (21, 22) du composant (2) de sorte à établir une continuité électrique entre l'au moins un connecteur électrique (21, 22) du support (1) et l'au moins un connecteur électrique (21, 22) du capot (6).
- Le système comprend plusieurs dispositifs en superposition suivant la dimension en épaisseur; le capot (6) d'un premier dispositif formant le support (1) d'un deuxième dispositif, chacun des dispositifs comportant un passage (61, 62) de sorte à ce que, l'au moins un connecteur électrique (21, 22) de chacun des dispositifs soit mis en continuité électrique par le matériau conducteur formant une reprise de contact (81, 82) du système commune auxdits dispositifs.
- le cordon de scellement (7) comprend un deuxième cordon (72) ; le deuxième cordon (72) formant un contour fermé autour d'une partie du composant, une portion de l'au moins un connecteur électrique (21, 22) n'étant pas entouré par ledit deuxième cordon (72).
- une couche de scellement déposée sur toute la surface de la première face du capot (6) et/ou de la première face du substrat (1), forme en partie au moins le cordon de scellement (7).
- l'étape de mise en place du capot (6) comprend une étape de compression du cordon de scellement (7). Par ailleurs la compression peut être obtenue par mise en pression mécanique du cordon entre le capot et le substrat à l'aide par exemple d'un piston.
- le cordon de scellement (7) comprend un matériau compressible et peut être à base de pâte de verre. La largeur du cordon peut correspondre à entre 0,5% et 2% (et de préférence à 1%) de la largeur du capot pour rigidifier l'ensemble.
- Le système comprend au moins un deuxième accès à au moins un deuxième connecteur électrique (21, 22) ; ledit capot (6) comportant au moins un deuxième passage (61, 62) suivant une dimension en épaisseur du capot (6), le matériau conducteur remplissant au moins le premier passage (61) formant une première reprise de contact (81) en continuité électrique avec le premier connecteur électrique (21) et le deuxième passage (62) formant une deuxième reprise de contact (82) en continuité électrique avec le deuxième connecteur électrique (22).
- le support (1) et/ou le capot (6) sont/est formé(s) en un matériau à base de verre et/ou transparent.
- le au moins un composant (2) comprend, successivement et dans l'ordre, une première électrode (3) déposée sur le support (1), une couche intercalaire (4) déposée au contact d'au moins une partie de la première électrode (3), une deuxième électrode (5) déposée au contact d'au moins une partie de la couche intercalaire (4) ; la première électrode (3) étant en continuité électrique avec le premier connecteur électrique (21) et la deuxième électrode (5) étant en continuité électrique avec le deuxième connecteur électrique (22).
- Le au moins un composant est une batterie.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Le capot placé sur le support n'implique donc pas nécessairement un contact entre ces deux éléments ; au contraire, un espace est préférentiellement préservé, en formant une cavité.

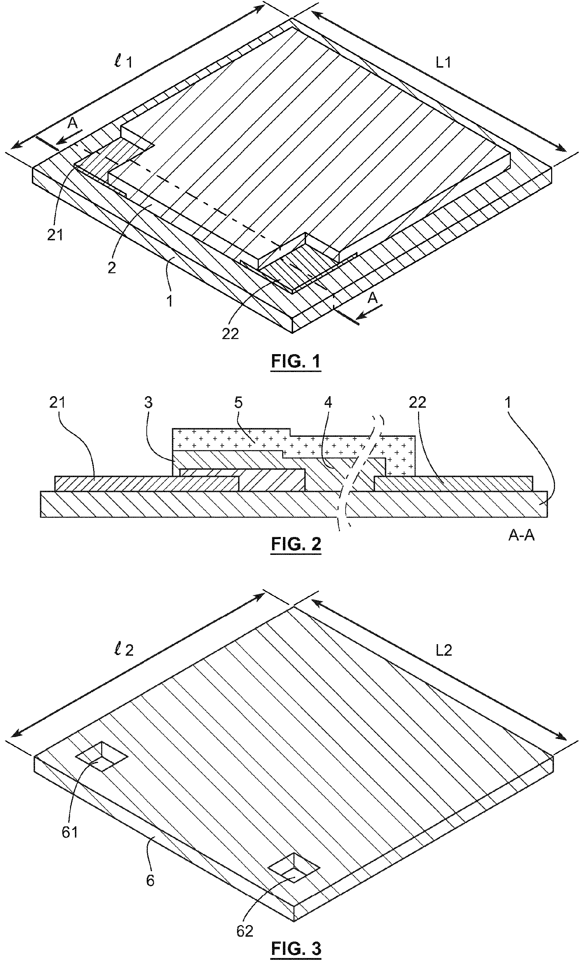

Il est précisé que dans le cadre de la présente invention, l'épaisseur d'une couche se mesure selon une direction perpendiculaire à la surface selon laquelle cette couche présente son extension maximale. Sur la figure 2 par exemple, l'épaisseur est prise selon la verticale.

L'invention concerne un procédé de réalisation d'un système électrique, de préférence un dispositif microélectronique. Selon l'invention, on entend par dispositif microélectronique, un dispositif comportant des éléments de dimensions microniques et/ou nanométriques. Il en va de même du terme « composant électronique ». Tout système ayant pour son fonctionnement au moins un élément électrique entre dans le cadre de l'invention.

Le procédé qui suit a pour but préférentiel de réaliser un dispositif (micro)électronique en référence aux figures 1 à 11. On entend préférentiellement par substrat, une puce ou une plaque (plus communément dénommée « wafer », en anglais) comprenant au moins une puce.

Dans la description qui suit, le terme substrat hôte ou substrat d'accueil fait référence au support 1 et/ou au capot 6 sur lequel le composant microélectronique a été disposé.

La présente invention propose une solution d'encapsulation des dispositifs sensibles à l'air basée sur le principe de cavité étanche et hermétique obtenue par report de capot palliant aux inconvénients de l'art antérieur. En particulier, la solution d'encapsulation proposée dans la présente invention autorise un accès facile aux plots de sortie des dispositifs par la réalisation de vias débouchant dans le capot, avantageusement sans altérer l'étanchéité et l'herméticité de la solution d'encapsulation. Avantageusement, l'un des attraits principaux d'une telle solution réside dans sa compatibilité avec les procédés d'assemblage permettant de relier de façon verticale un ou plusieurs dispositifs. Ainsi, la présente invention permet une encapsulation performante avec un encombrement géométriquement adapté à la taille du composant, tout en facilitant les étapes d'intégration et d'assemblage.

L'une des applications potentielles de cette technique concerne l'encapsulation et l'assemblage de dispositifs, réalisées à partir de substrats en couches minces. Plus précisément, l'invention a pour objet la fourniture d'une solution d'empilement de plusieurs composants tout en garantissant une herméticité. En particulier, l'une des applications majeures du principe de cette invention concerne l'intégration en trois dimensions ou l'intégration 3D de composants réalisés sur des supports transparents et encapsulés par des capots transparents. Dans ce cas, les capots employés constituent des supports pour la réalisation de composants électroniques qui peuvent être identiques ou différents au composant embarqué par le support formant le substrat d'accueil. A titre d'exemple, le capot d'encapsulation peut être un support pour la réalisation de composants, par exemple de micro-batteries, de dispositifs électrochromes, de cellules photovoltaïques ou tout autre dispositif microélectronique, optronique ou électromécanique. Ainsi, cette approche peut être exploitée pour la réalisation de systèmes de récupération et de stockage d'énergie. D'une manière générale, les procédés d'assemblage 3D permettent de relier verticalement un ou plusieurs dispositifs situés sur un ou plusieurs niveaux afin d'apporter une réponse aux problématiques de miniaturisation, de densification de l'intégration et de réduction des coûts de fabrication. L'approche adoptée dans l'état de l'art consiste, le plus souvent, à empiler plusieurs composants en utilisant des techniques de collage d'une série de puces unitaires. Les assemblages obtenus présentent plusieurs inconvénients limitatifs comme l'encombrement du « packaging » par rapport aux couches actives, la complexité des interconnexions ou encore l'absence d'étanchéité latérale. Un inconvénient est généralement la manque d'étanchéité relativement à l'environnement externe.

Le procédé d'encapsulation proposé dans le cadre de cette invention est basé sur l'enfouissement du dispositif microélectronique contenant des plots de sortie dans une cavité définie d'un côté par un cordon de scellement et de l'autre côté par un capot rapporté avec un ou plusieurs passages traversants. Une telle cavité est géométriquement délimitée par le substrat actif, le capot d'encapsulation ainsi que le cordon de scellement qui entoure de manière indépendante le dispositif microélectronique de ses plots de contacts qui se trouvent au regard des passages créés dans le capot d'encapsulation. Avantageusement, le cordon de scellement est formé en un matériau isolant électriquement.

Un autre objet d'un mode de réalisation de la présente invention est de prévoir des ouvertures d'accès aux connecteurs électriques au niveau du support contenant le composant microélectronique. Sur le plan du procédé de mise en oeuvre, le scellement du capot d'encapsulation peut se faire sous atmosphère inerte contrôlée afin d'assurer une isolation du dispositif microélectronique par rapport à l'environnement extérieur garantissant ainsi une intégrité et une durée de vie prolongée.

La description donnée dans la suite de ce document fera référence à un dispositif particulier de micro-batterie au lithium, étant entendu que cet exemple est donné à titre illustratif et non limitatif. Il peut être transposé à tout composant électronique, optique, optoélectronique, micromécanique ou autre. Pour mieux illustrer les principes de cette invention, nous nous baserons sur cet exemple comprenant au moins un composant de type micro-batterie au lithium réalisé sur un substrat fin en verre, par exemple d'une épaisseur de 50 microns.

Selon un mode de réalisation préféré mais non limitatif de l'invention, les étapes de réalisation d'un système électrique comprenant au moins un composant 2, par exemple de type micro-batterie au lithium, peuvent être effectuées comme cela est illustré sur les figures 1 à 11.

D'une manière générale, le composant 2 (par exemple, une micro-batterie) est réalisé par des techniques connues dans l'état de l'art antérieur. Les dimensions et les épaisseurs des couches constituant le composant 2 et en particulier la micro-batterie, sont données à titre illustratif pour représenter les principes de l'invention.

La **figure 1** illustre une vue de dessus d'un composant 2 de type batterie unitaire comprenant un premier connecteur électrique 21 et un deuxième connecteur électrique 22. Le composant 2 est disposé sur un support 1. Les dimensions de largeur et de longueur du support 1 sont représentées, respectivement, par les valeurs l₁ et L₁. La **figure 2** illustre une vue en coupe d'un composant 2 formant une batterie unitaire. Le composant comprend un premier connecteur électrique 21, de préférence cathodique et un deuxième connecteur électrique 22, de préférence anodique. Avantageusement, les connecteurs électriques 21, 22 comprennent un matériau métallique. Ils sont par exemple formés à base de titane, d'or, d'aluminium, de platine, de tungstène, ou de tout autre métal pouvant être utilisé en tant que connecteur électrique. Selon un exemple de réalisation non limitatif de l'invention, les connecteurs électriques 21, 22 sont d'une épaisseur de 0,5 micron. Les connecteurs électriques 21, 22 sont formés sur une première face du support 1. Selon un mode de réalisation préféré, les connecteurs électriques 21, 22 sont en contact direct avec le support 1. La face du support 1 où a lieu ce contact est de préférence diélectrique.

Le support 1 peut contenir un composant ou une pluralité de composants 2. Selon un mode de réalisation préférentiel, le support 1 est formé en un matériau, par exemple à base de verre par exemple du type de la famille des borosilicates, notamment d'une épaisseur de 50 microns, caractérisé par un coefficient d'expansion thermique (acronyme « CET ») à 20°C, de 7,2×10⁻⁶ K⁻¹ et une température de transformation Tg de 557°C.

Le composant 2 peut comprendre un empilement de couches ; l'empilement comprenant des couches actives plus au moins sensibles à l'air. Ces couches sensibles comprennent une première électrode 3, une deuxième électrode 5 et une couche intercalaire 4. De préférence, la première électrode 3 est déposée sur le support 1. La couche intercalaire 4 est déposée au contact d'au moins une partie de la première électrode 3. La deuxième électrode 5 est déposée au contact d'au moins une partie de la couche intercalaire 4.

Le composant 2 peut par exemple avoir un contour extérieur à bords rectilignes. De préférence, l'empilement de couches comprend, au niveau de chaque connecteur 21, 22, un décrochement, par exemple un coin en retrait formant un angle de 90°, de sorte à définir une zone du composant où seul le connecteur 21, 22 est exposé. Cette zone exposée de chaque connecteur 21, 22 peut prendre toute forme et tout emplacement adapté à l'application souhaitée. De préférence, cette zone est en périphérie du reste du composant électronique.

Lors d'une première étape, illustrée en **figure 2**, on forme la première électrode 3. Selon un mode de réalisation avantageux, la première électrode 3 chevauche en partie le premier connecteur électrique 21. En d'autres termes, la première électrode 3 est avantageusement réalisée de sorte à ce qu'une première partie soit positionnée au-dessus du premier connecteur électrique 21 et une deuxième partie soit positionnée directement au-dessus du support 1. La première électrode 3 et le connecteur électrique 21 sont avantageusement en continuité électrique.

Selon un exemple de réalisation, la première électrode 2 est une électrode dite « positive », comprenant un matériau ayant une bonne conductivité électronique et ionique, par exemple choisi parmi : TiOS, TiS₂, LiTiOS, LiTiS₂, LiCoO₂, V₂O₅, etc. La première électrode 2 présente, par exemple, une épaisseur de 5 microns.

La couche intercalaire 4, forme de préférence un isolant électronique avec une forte conductivité ionique. Selon un exemple, la couche intercalaire 4 forme un électrolyte. Le LiPON est, par exemple, l'électrolyte le plus employé dans la technologie des micro-batteries, mais il existe d'autres matériaux comme le LiPONB, LiSiCON, qui conviennent également en tant que couche intercalaire. La couche intercalaire 4 comprend, par exemple, une épaisseur typique de 2 microns. Selon un mode de réalisation, la deuxième électrode 5 est une électrode dite négative, d'une épaisseur par exemple de 2 microns. La deuxième électrode 5 peut être constituée exclusivement de lithium métallique, dans le cas d'une batterie en lithium métal, ou d'un matériau sciemment lithié, dans le cas d'une batterie en lithium ion. Les batteries en lithium métal sont extrêmement sensibles aux espèces oxydantes. De ce fait, elles requièrent un niveau d'encapsulation plus élevé en comparaison aux batteries dites lithium ion.

Selon un exemple de réalisation non limitatif de l'invention, la surface totale d'un composant 2, par exemple une batterie individuelle, comprenant les connecteurs électriques 21, 22 est de 1 centimètre x 1 centimètre et l'épaisseur totale est de l'ordre de 10 microns. Les dimensions surfaciques des connecteurs électriques sont, de préférence, identiques et données autour de 1 millimètre x 1 millimètre, par exemple.

La **figure 3** illustre un capot 6 doté d'un premier passage 61 et d'un deuxième passage 62, suivant une dimension en épaisseur du capot 6. Selon un mode de réalisation préférentiel, les passages 61, 62 de type « vias » sont réalisés dans les capots 6 d'encapsulation qui seront rapportés sur le support 1 contenant au moins un composant 2. Le capot 6 d'encapsulation est de préférence choisi en verre, par exemple d'une épaisseur de 50 microns et/ou choisi dans les matériaux déjà décrits en référence au support 1. Cependant, ce principe peut être élargi à d'autres matériaux de supports 1 et de capots 6 caractérisés par d'autres épaisseurs et d'autres propriétés optiques, thermiques ou mécaniques. Le capot 6 d'encapsulation préconisé dans cet exemple de réalisation est un verre transparent aux rayonnements infrarouges et/ou proches de l'infrarouge. Les valeurs caractéristiques de transmission optique dans les longueurs d'ondes souhaitées et d'indice de réfraction sont, par exemple de l'ordre de 91.7% et 1.523, respectivement. Les dimensions géométriques du capot 6 d'encapsulation schématisées par les valeurs l₂ et L₂ de la figure 3 sont de préférence identiques à celles définies par le composant 2 et ses connecteurs électriques 21, 22 avec une déviation des valeurs largeur-longueur de ±1%. Le capot d'encapsulation 6 peut être un substrat passif sans couche active, un substrat avec éléments électriques ou bien un substrat avec un ou plusieurs composants de même nature ou de nature différente. Le critère prédominant dans le choix des matériaux constituant le capot 6 est dicté par les propriétés barrières requises par l'application visée. Ces capots 6 d'une épaisseur préférentiellement inférieure à 100 microns peuvent être de nature métallique, céramique, verre ou tout autre matériau ou combinaisons de matériaux permettant de garantir une étanchéité suffisante vis-à-vis des espèces oxydantes telles que par l'exemple : l'eau H₂O, l'oxygène O₂, ou/et l'azote N₂.

En fonction de l'application visée, d'autres critères d'ordre optique (transparence et transmittance), thermique, chimico-physique (résistance à la corrosion) ou mécanique peuvent être exigés. De manière préférée, les capots 6 sont choisis dans la large gamme des différentes familles de verres (borofloates, borosilicates ou leurs dérivés) commercialisés par plusieurs verriers sous différentes dénominations, à des épaisseurs inférieures ou égale à 100 microns. De manière préférée, le matériau du capot est choisi en cohérence par rapport aux propriétés mécaniques et/ou thermiques du matériau du support. On peut de préférence faire en sorte que le CTE du matériau du capot et celui du support soient identiques ou diffèrent l'un de l'autre au maximum d'un rapport de 2.

La réalisation du capot d'encapsulation 6 est subdivisée en deux étapes élémentaires ; l'ordre suivant est purement indicatif. Une première étape comprend la réalisation de passages 61, 62 préférentiellement traversants suivant une dimension en épaisseur du capot 6, permettant d'accéder aux connecteurs électriques 21, 22. Les dimensions de ces passages 61, 62 sont définies par la taille des connecteurs électriques 21, 22 du composant microélectronique situé au niveau du substrat d'accueil 1. En utilisant des techniques lasers dédiées (ablation, filamentation), il est possible d'envisager la réalisation de vias traversants ou passages 61, 62 dans des capots 6 en verre d'un diamètre variable de quelques millimètres à quelques microns, sur une profondeur de moins de 100 microns. Alternativement, les opérations de création des passages 61, 62 peuvent être conduites grâce aux techniques d'abrasion par voie chimique. Avantageusement, au moins un des passages 61, 62 est située uniquement en regard d'un connecteur 21, 22 ou d'une partie de celui-ci. Ainsi, le passage considéré forme un accès dédié à une portion totale ou partielle de la surface supérieure du connecteur.

Une deuxième étape comprend le dépôt d'un cordon de scellement 7 dans une zone périphérique du composant 2. Avantageusement, les passages 61, 62 débouchent sur une surface qui représente la moitié de la surface non recouverte par d'autres couches de chacun des deux connecteurs électriques 21, 22. Selon un mode de réalisation préférentiel, deux passages identiques 61, 62 situés au regard des connecteurs électriques 21, 22, par exemple de largeur ou de diamètre de 500 microns, sont obtenus dans le capot 6, après des opérations classiques d'ablation laser définies dans l'état de l'art, par exemple le laser excimère, laser YAG, acronyme faisant référence à l'utilisation comme amplificateur d'un grenat d'yttrium-aluminium dopé, etc. Les passages 61, 62 peuvent être réalisés sous différentes formes géométriques, par exemple rectangulaire (dont carrée), ovale, etc.

Les passages assurent un accès électrique sans remettre en cause l'encapsulation à produire. Celle-ci s'entend d'une mise en place du composant électronique 2 dans une cavité de sorte à le protéger au moins en partie contre les effets de son environnement dont l'humidité. Cette encapsulation n'est pas forcément totale ; par exemple une partie du composant 2 notamment au niveau des connecteurs 21, 22 peut rester exposée. L'encapsulation est produite par un cordon de scellement 7 formant au moins une paroi à contour fermé autour d'au moins une partie du composant 2.

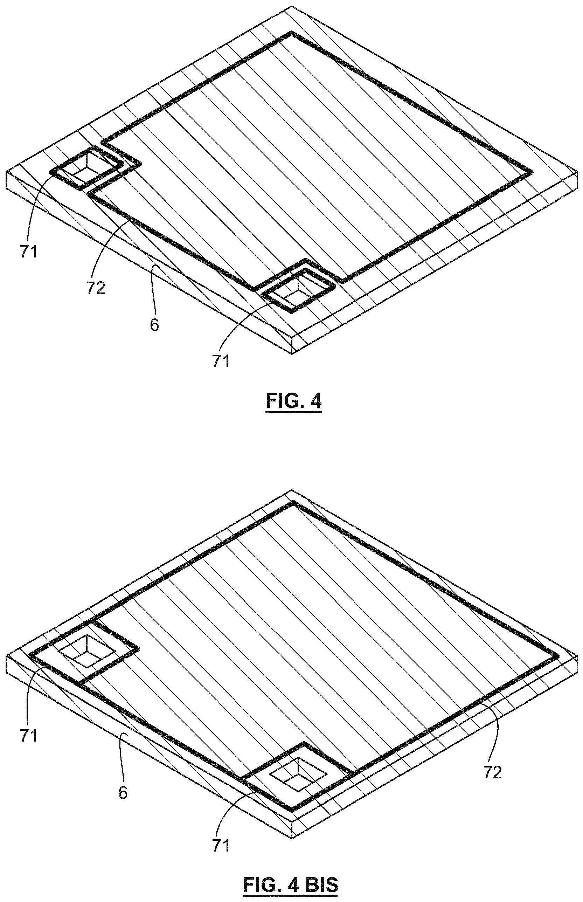

Selon un mode de réalisation particulier, la construction du cordon de scellement 7 au niveau du capot d'encapsulation 6 est conçue dans le but d'entourer séparément les couches actives du composant 2 et les connecteurs électriques 21, 22. Ainsi, le cordon périphérique de scellement 7 est agencé, sur une première face du capot 6 appelée à être mise en contact avec une première face du support 1, avec une faculté permettant de créer trois zones distinctes schématisées par la **figure 4****.** Les deux premières zones sont définies par les parois d'un premier cordon de scellement 71 qui délimitent les passages traversants 61, 62. On forme ainsi avantageusement une partie d'espace délimitée par la face supérieure du connecteur, le capot et la paroi latérale intérieure du premier cordon de scellement 71. De préférence, le cordon de scellement 71 s'étend uniquement autour du passage qui lui correspond. Typiquement, un cordon de scellement s'entend ici d'un objet tridimensionnel présentant une dimension longitudinale correspondant aux traits épaissis visibles sur les figures et une épaisseur orientée suivant l'épaisseur du support et une largeur orientée perpendiculairement aux deux dimensions précédentes et s'inscrivant dans une échelle dimensionnelle bien plus faible (par exemple au moins dix fois) que celle de la dimension longitudinale. Ainsi, le premier et/ou le deuxième cordon sont des motifs allongés. De préférence, le premier cordon 71 est réalisé à proximité immédiate de l'embouchure du passage 61, 62, au niveau de la face inférieure du capot 6. Par exemple, le premier cordon peut réaliser un contour fermé autour du passage ce contour définissant une surface intérieure dans la superficie n'est pas plus grande que huit fois la superficie de la section du passage et avantageusement pas plus grande que quatre fois celle-ci.

La troisième zone résulte de l'encadrement des parties actives du composant 2 par un deuxième cordon de scellement 72. Le premier cordon 71 et le deuxième cordon 72 forment au moins en partie le cordon de scellement 7. Les trois zones peuvent être réalisées en une seule étape technologique ou bien en plusieurs étapes. Cependant, la hauteur des parois du premier cordon 71 et du deuxième cordon 72, autrement dit l'épaisseur du cordon de scellement 7, caractéristiques des trois zones, sont de préférence identiques. La représentation de la figure 4 est schématique et montre en traits gras le lieu de formation des parties du cordon non encore irradié.

Selon un mode de réalisation de l'invention, l'épaisseur du cordon de scellement 7 est avantageusement choisie de sorte à créer une cavité 9 entre le support 1 et le capot d'encapsulation 6 nécessaire pour une fonctionnalité électrique correcte sans altérer les cycles de charge/décharge du composant 2, dans ce cas d'une batterie. Ces cycles, correspondant à un phénomène d'insertion/désinsertion du lithium entre les première et deuxième électrodes 2, 5, se traduisent généralement par des phénomènes d'expansion volumique desdites électrodes 2, 5. Il est donc utile de dégager une cavité 9 pour un libre mouvement vertical des électrodes 2, 5. La hauteur d'une telle cavité 9 est définie par la différence entre l'épaisseur du cordon de scellement 7 et celle de l'empilement des couches du composant 2, formant la batterie. Typiquement, la valeur minimale de cette hauteur est fixée autour de 5% de la valeur de l'épaisseur totale du composant 2. Les dimensions planaires des parois du cordon de scellement 7, définissant les trois zones sont optimisées en fonction de la taille des éléments à protéger afin de réduire efficacement l'encombrement du « packaging » par rapport à la surface totale du dispositif microélectronique. Ainsi, la largeur du cordon de scellement 7 peut être réduite jusqu'à 100 microns sans altérer les propriétés d'étanchéité et de tenue mécanique dudit cordon de scellement 7. D'autre part, le diamètre intérieur des zones séparant les parois des cordons de scellement 7, 71, 72 est a minima égal à celui des passages 61, 62. En revanche, la longueur du cordon de scellement 7 est identique à celle définie par les dimensions du composant 2 et du capot d'encapsulation 6. Ces dimensions atypiques du cordon de scellement 7, préconisées dans ces exemples de réalisation, peuvent être ajustées selon les applications. Avantageusement, le capot n'entre pas en contact avec le support ou des éléments portés par ce dernier. Notamment, il est préféré que les connecteurs 21, 22 ne soient pas au contact du capot 6 après assemblage.

Les cloisons de séparation définissant les trois zones constituent le cordon de scellement 7. Ce sont en fait des piliers étanches de consolidation mécanique de l'empilement formé par le capot d'encapsulation 6 et le substrat hôte 1. En premier lieu, en raison de leurs propriétés barrières, ces cloisons garantissent une encapsulation latérale de la micro-batterie le long de sa périphérie ainsi que les passages 61, 62 autorisant l'accès aux connecteurs électriques 21, 22. De par sa répartition géométrique dans différentes zones du capot d'encapsulation 6, le cordon de scellement 7 couvre, selon un mode de réalisation préféré, tout le périmètre périphérique défini par les dimensions du composant 2 et de ses connecteurs électriques 21, 22. Une telle disposition du cordon de scellement 7 contribue efficacement à une robustesse mécanique accrue de l'assemblage capot 7 - support 1, en remédiant à la présence de zones de fragilité au niveau des connecteurs 21, 22. Dans le cas de la figure 4, le cordon, non encore irradié, est présenté sous forme de lignes en gras. Les dimensions en hauteur sont ici schématiques par soucis de simplification de la compréhension et ne sont pas représentatives de la réalité.

Dans un cas non illustré, le cordon 72 parcourt la périphérie de l'ensemble du composant 2, en étant en contact, dans sa totalité avec la première face du composant 2. Les cordons 71 sont toujours situés au niveau des connecteurs 21, 22, et plus précisément autour des passages 61, 62 (ou 63, 64 pour le support 1) pour former une paroi pleine et continue au droit des passages, à partir du capot 6. Comme dans le cas précédent, ce cordon 71 délimite latéralement un espace débouchant au niveau des passages 61, 62, 63, 64. Cet espace est isolé électriquement vis-à-vis du reste du composant 2 et son remplissage par un matériau conducteur, qui sera décrit ensuite, n'a pas de conséquence négative. Avant l'étape de remplissage, cet espace est vide et rien ne s'oppose au remplissage. De plus cette paroi issue du cordon 71 forme un élément d'encapsulation du composant 2 autour du passage considéré. Dans le cas de la **figure 4****bis**, le cordon 71 forme un contour fermé autour des passages 61, 62. Le cordon 72 est situé autour d'une majeure partie d'une zone destinée à être en regard du composant à encapsuler. Le cordon 72 est ici un contour non fermé qui rejoint les cordons 71. Le cordon 72 comporte alors un tronçon droit entre deux points des deux cordons 71, et un tronçon en « U » joignant deux autres points des deux cordons 71.

La formation du cordon périphérique 7 peut être réalisée en une seule étape par des techniques de dépôt en utilisant de préférence une pâte de verre. En plus de ses propriétés intrinsèques barrières vis-à-vis des espèces oxydants (valeurs WVTR et OTR ~10⁻⁶ gm⁻²j⁻¹), ce produit a de préférence des caractéristiques thermiques (CET à 20°C de l'ordre de 7,7×10⁻⁶.K⁻¹) très proches de celles du support 1 et du capot d'encapsulation 6 (CET à 20°C de l'ordre de 7,2×10⁻⁶ K⁻¹). En outre, ce produit présente l'avantage d'une habilité de scellement à des temps relativement courts sous irradiation laser (60 secondes selon un mode de réalisation), limitant ainsi les risques de propagation de chaleur durant l'étape de scellement.

Alternativement aux techniques de dépôts localisés de dispense ou de sérigraphie, la pâte de verre employée peut être déposée sur toute la surface du capot d'encapsulation 6 en utilisant des techniques de l'état de l'art comme le dépôt par tournette ou par enduction. Après l'étape de vitrification thermique, la pâte de verre est figée mécaniquement sur le capot d'encapsulation 6. En revanche, l'irradiation laser nécessaire pour la réalisation du cordon de scellement 7 s'effectue de manière localisée sur des dimensions équivalentes à celles définies précédemment. Dans ce cas de figure, la cavité 9, non remplie, de la configuration de base est remplacée par un polymère favorable aux sollicitations mécaniques des deux électrodes 2, 5. Avantageusement, cette approche peut être considérée comme une consolidation mécanique de l'assemblage pour l'emploi de support 1 ou de capots d'encapsulation 6 ultrafins (inférieurs à 25 microns).

Cette deuxième option permet aussi la réalisation du cordon de scellement 7 par dépôt de la couche de scellement directement sur la première face du substrat 1 contenant les couches actives du composant 2 et les connecteurs électriques 21, 22. Cette option présente l'avantage de simplifier les procédés d'assemblage dans le cas où le capot d'encapsulation 6 comprend un ou plusieurs composants actifs 2.

Le polymère de remplissage peut être évacué au niveau des passages avant l'étape de solidification, en particulier par laser.

Après l'étape de dépôt de la pâte de verre par la technique de dispense, le cordon de scellement 7 est, par exemple, obtenu à l'issu du procédé de vitrification par exemple à une température de 150°C pendant 30 minutes permettant ainsi le dégazage des produits organiques (10 à 15% en volume) présents initialement dans la pâte de verre. A titre d'exemple applicatif, l'épaisseur et la largeur du cordon de scellement 7 déposé sur le capot d'encapsulation 6, par exemple en verre de type D263T, sont, respectivement, de l'ordre de 50 microns et de 100 microns. Le diamètre intérieur ou la plus grande largeur des zones qui entourent les passages 61, 62 est, par exemple, de 500 microns et le périmètre de la zone qui englobe les couches actives du composant 2 est, par exemple, de l'ordre de 4 centimètres. C'est l'étape ultime qui permet de réaliser un assemblage support 1-capot 6 par un scellement laser du cordon 7.

Le procédé de soudure par laser est basé sur un rayonnement localisée qui peut être appliqué sur l'un des côtés du cordon de scellement 7 en contact avec le capot 6 et le substrat actif 1. Cela engendre une fusion du matériau, par exemple de la pâte de verre, sous l'effet du chauffage laser conduisant à un collage du capot 6 sur le support 1. Le capot 6 et/ou le support 1 sont de préférence transparents (notamment plus de 90% de transmission) dans la gamme des longueurs d'onde correspondant au laser choisi.

Le scellement par soudure d'une fritte de verre est une méthode simple et robuste qui offre une solution préférée. L'un des principaux avantages de cette technique est lié à sa facilité de mise en oeuvre indépendamment de la planéité des surfaces à coller en raison de ses fortes capacités de mouillage. D'une manière générale, l'étanchéité des cordons de scellement 7 est un critère recherché pour la solution d'encapsulation par report de capot 6.. Afin de réduire les problèmes de contrainte mécanique, il est souhaitable d'utiliser des matériaux avec des valeurs de CET les plus proches possible les uns des autres avec des variations de moins de 10% pour le capot 6, le support 1 et le cordon 7.

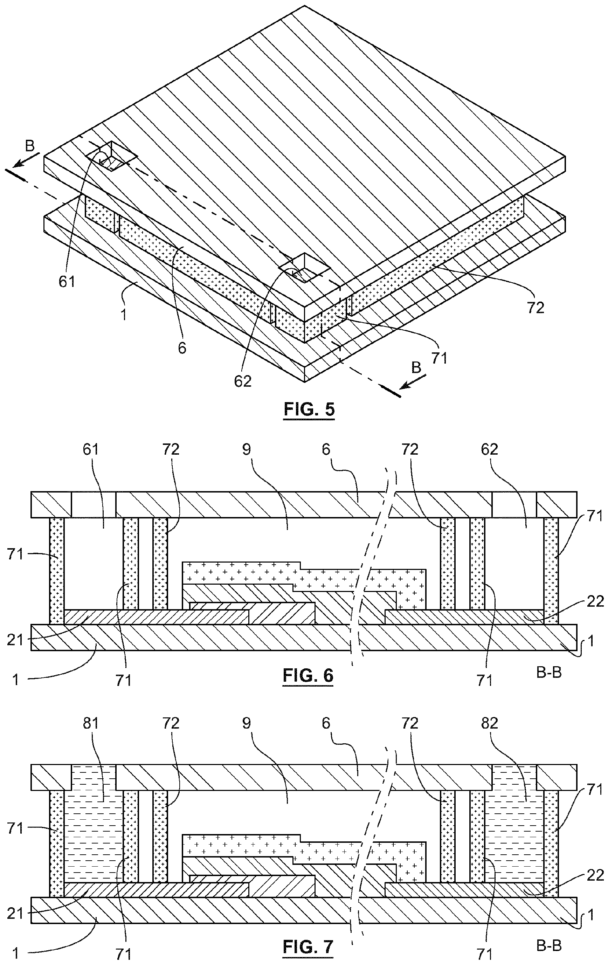

Selon un mode de réalisation représenté à la **figure 5****,** le capot d'encapsulation 6 est doté d'ouvertures 61, 62 et le cordon de scellement 7 est positionné, en utilisant des équipements de manipulation de la microélectronique (« pick and place »), pardessus le support 1 contenant les couches actives du composant 2 et les connecteurs électriques 21, 22. Ce positionnement est réalisé de façon à faire correspondre la face du capot 6 contenant les trois zones avec la première face (ou face active) du support 1. Avantageusement, les passages 61, 62 sont exploités pour garantir un alignement précis du capot d'encapsulation 6 par rapport au support 1. Ainsi, les passages 61, 62 se trouvent en regard direct des connecteurs électriques 21, 22. Par application d'une force de pression par exemple de l'ordre de 1 Newton, le cordon de scellement 7 se trouve de préférence en contact direct avec le support 1. Après l'étape de compression, l'assemblage substrat 1 - capot 6 est exposé à un rayonnement laser à l'aide d'une fibre dont la longueur d'onde caractéristique se situe dans le domaine du proche infrarouge, typiquement à 940 nanomètres. En pratique, une illumination laser à une puissance de 80 Watts pendant 60 secondes et une vitesse de déplacement de 2 mm/s est suffisante pour engendrer l'abrasion du cordon de scellement 7, permettant de sceller de façon permanente le capot d'encapsulation 6 et le support 1.

La **figure 6** illustre une vue en coupe d'un composant 2 logé dans une cavité 9 délimitée par la première face du support 1, la première face du capot 6 et le cordon de scellement 7. L'assemblage constitué par le composant 2 et le capot 6 est un ensemble solide mécaniquement avec un accès facile aux connecteurs électriques 21, 22. Les couches actives du composant 2 sont situées au moins pour partie dans une cavité 9 étanche définie par une jointure entre le capot 6 et le support 1. Optionnellement, la cavité 9 engendrée par le scellement du capot d'encapsulation 6 sur le support 1 comprenant le composant 2 peut être contrôlée en atmosphère, en réalisant les procédés de scellement sous gaz inerte (comme l'argon) ou sous vide.

Selon l'invention, le cordon de scellement 7 entoure et délimite les parties actives du composant 2 indépendamment des connecteurs électriques 21, 22 qui sont entourés séparément. Les zones crées par les parois délimitant les connecteurs électriques 21, 22 se trouvent avantageusement au regard des passages 61, 62 réalisés dans le capot d'encapsulation 6. De ce fait, il est possible d'accéder aux connecteurs électriques 21, 22 à travers les passages 61, 62, sans altérer l'étanchéité du composant vis-à-vis de l'environnement externe. De plus, cette solution garantie une robustesse mécanique accrue de l'ensemble constitué par le dispositif microélectronique et son packaging. Cet avantage majeur trouve son application dans les procédés d'assemblage tridimensionnel des composants microélectroniques en général et plus particulièrement les composants réalisés à partir de substrats ultrafins (épaisseur inférieure à 50 microns) nécessitant l'emploi des capots d'encapsulation ultrafins 6. En effet, dans un procédé standard de l'art antérieur, la mise en regard d'un substrat actif 1 avec son capot d'encapsulation 6 crée une zone de fragilité mécanique qui peut être schématisée par une casquette au niveau des parties définies par les connecteurs électriques 21, 22. Avantageusement, le remplissage des passages 61, 62 par un matériau conducteur est mieux canalisé en présence de parois formant un puit d'enfouissement du matériau conducteur.

La **figure 7** illustre l'étape de remplissage des passages 61, 62 par un matériau conducteur permettant ainsi de déporter les contacts électriques ou connecteurs 21, 22 par rapport aux différentes couches actives du composant 2. Le remplissage peut, par exemple, être complété en utilisant des techniques appropriées définies dans l'état de l'art : remplissage avec un polymère liquide conducteur, laminage d'un film conducteur ou électrodéposition de couches conductrices. D'une manière générale, il est avantageux d'utiliser un matériau à l'état liquide lors du remplissage proprement dit puis de solidifier ce matériau une fois qu'il a rempli l'espace défini par le cordon de scellement 7. De manière préférentielle, cette étape peut être réalisée en employant une solution en polymère liquide conducteur suivi d'un traitement thermique adéquat. Avantageusement, la présence des parois du cordon de scellement 7 facilite la canalisation et l'écoulement des polymères liquides. A titre d'exemple illustratif mais non limitatif de l'invention, les polymères conducteurs permettent d'accomplir la fonctionnalité de remplissage des accès obtenus par la superposition des passages 61, 62 sur les parois après un traitement thermique à 150°C pendant une durée de 15 minutes.

Le remplissage de l'invention n'impose pas que le matériau conducteur remplisse intégralement l'espace entre le cordon 71 et le passage considéré, même si cela est préféré. En outre, différents matériaux de remplissage peuvent être employés pour remplir des passages différents.

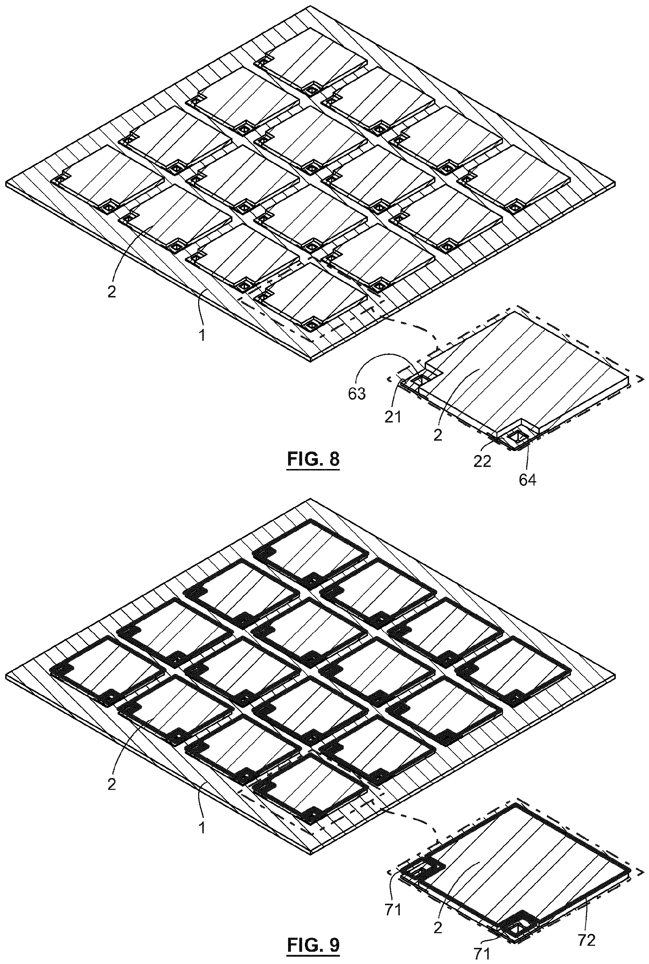

La **figure 8** illustre un exemple de réalisation particulier où le composant 2, par exemple une batterie, comprend deux passages 63, 64 qui traversent les connecteurs électriques 21, 22 du composant 2. L'empilement des couches actives formant le composant 2 est réalisé avec les mêmes procédés énoncés précédemment. Le support 1 est préférentiellement un matériau transparent, par exemple en verre. Chaque composant 2 dispose de deux passages 63, 64 qui traversent le support 1, créés par les techniques précédemment décrites, au niveau des connecteurs électriques 21, 22. Selon un mode de réalisation, ces passages 63, 64 sélectives sont réalisées après la formation de l'empilement des couches formant le composant 2. Cela permet un accès de reprise de contact par le dessous du support 1. La figure 8 montre en outre que le support 1 peut être une plaque servant de support, pour la fabrication, à une pluralité de composants électroniques. Le procédé de l'invention peut donc être mutualisé pour plusieurs composants.

La **figure 9** illustre un exemple de réalisation particulier où le cordon de scellement 7 est formé sur la première face du support 1. Le cordon de scellement 7 est formé directement sur le support 1 contenant le composant 2. Les zones, identifiées par les parois du cordon de scellement 7, entourent les ouvertures 63, 64 réalisées au niveau des connecteurs électriques 21, 22. Une des zones est définie par les couches actives du composant 2 entourées par les parois du cordon de scellement 7.

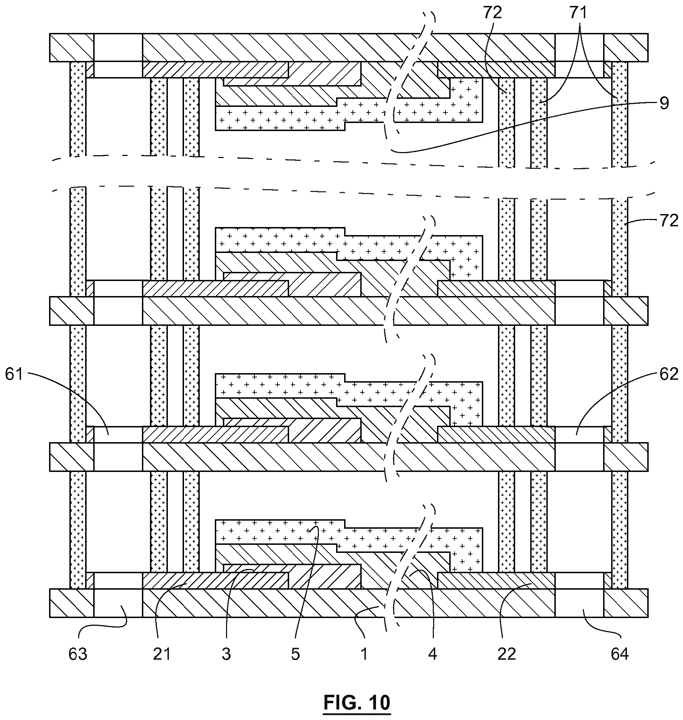

La **figure 10** illustre une vue en coupe d'un exemple de réalisation particulier comprenant une pluralité de dispositifs empilés. Les dispositifs, et en particulier les composants 2 de chacun des dispositifs, peuvent êtres empilés les uns sur les autres, en respectant un mode de réalisation selon un montage série ou un montage parallèle. Contrairement aux autres composants constituant le cœur de l'assemblage, le composant 2 du dernier étage qui permet de refermer l'assemblage est monté tête bèche. Autrement dit, le composant 2 du dernier étage est monté sur la première face du capot 6 qui forme dans ce cas le support du composant en question ; ce composant 2 étant en regard du composant 2 monté sur la première face du support 1. Il est possible de remplacer le dispositif du dernier étage par un simple capot 6. L'application d'une irradiation laser adaptée permet de sceller, de façon pérenne, les différents dispositifs, réalisant de ce fait un ensemble étanche et robuste avec une intégration qui offre une réduction de l'encombrement du packaging. Le capot 6 peut donc lui-même faire office de support pour un ou plusieurs composants 2.

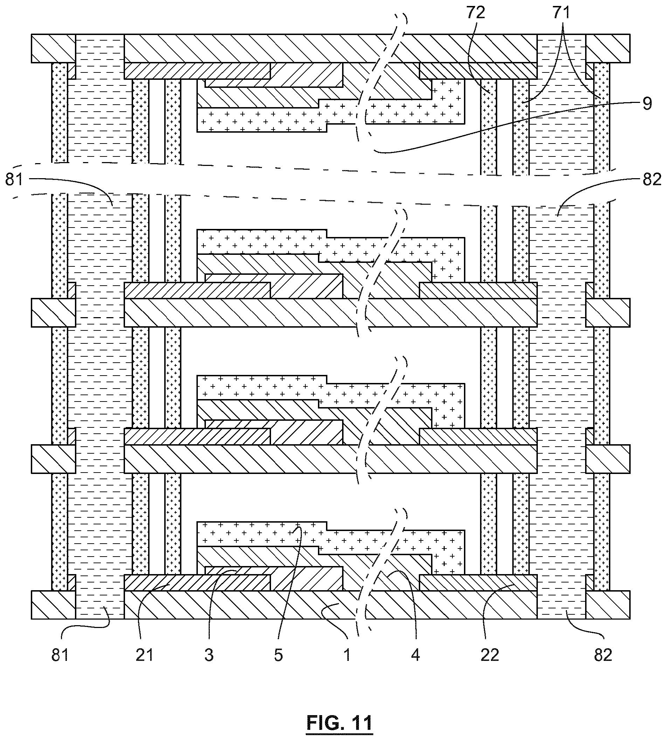

La **figure 11** illustre une vue en coupe d'un exemple de réalisation particulier où les dispositifs sont empilés et coopèrent afin de former des vias traversants. Le remplissage des vias peut être effectué en une seule étape à l'aide d'un matériau conducteur, par exemple une colle conductrice. La présence des parois du cordon de scellement 7 permet une meilleure maitrise de l'étape de remplissage. En effet, le volume des passages 61, 62 est complètement comblé par le matériau conducteur. Cela permet de renforcer et d'optimiser la surface de contact entre le matériau conducteur et les connecteurs électriques 21, 22, permettant ainsi d'améliorer la qualité des reprises de contacts électriques 81, 82, et permettant un déport des reprises vers l'extérieur de l'assemblage.

L'invention n'est pas limitée aux modes de réalisation précédemment décrits, mais s'étend à tous les modes de réalisation relevant du cadre des revendications. Les variantes ou options décrites dans cette partie découlent directement du descriptif des étapes technologiques précédentes. Elles sont valables pour les applications illustratives comme les micro-batteries mais peuvent être transposables sur d'autres composants microélectroniques. Sauf indication contraire, les étapes qui décrivent les exemples présentés dans chaque partie sont basées sur les mêmes principes précédemment énoncés.

Les passages 63, 64 permettant l'accès aux connecteurs électriques, peuvent être réalisés dans le substrat d'accueil 1 au niveau des connecteurs électriques 21, 22 en utilisant des techniques semblables à celles décrites précédemment. Cette option offre l'avantage, après remplissage des vias ou passages 61, 62, de fournir un deuxième accès aux connecteurs électriques 21, 22, alternatif à l'accès du côté du capot d'encapsulation 6.

## Revendications

1. Procédé de réalisation d'un système électrique comprenant au moins un dispositif comprenant un support (1) portant sur une première face au moins un composant électronique (2) doté d'au moins un connecteur électrique (21, 22), le procédé comprenant :
- une étape de mise en place d'un capot (6) au-dessus du composant, ledit capot (6) comportant au moins un passage (61, 62) suivant une dimension en épaisseur du capot (6) de sorte à former un accès à l'au moins un connecteur électrique (21, 22),
- une étape de formation d'un cordon de scellement (7) de sorte que le composant soit au moins en partie situé dans une cavité (9) délimitée par la première face du support (1), la première face du capot (6) et le cordon de scellement (7), ladite étape de formation étant configurée pour que le cordon de scellement (7) comprenne un premier cordon (71) au niveau de l'au moins un connecteur électrique (21, 22); le premier cordon (71) s'étendant autour de l'au moins un passage (61, 62) en un contour fermé formant une paroi pleine et continue délimitant latéralement un espace débouchant au travers de l'au moins un passage (61, 62) ;
le procédé comprenant une étape de remplissage, opérée après l'étape de formation, par un matériau électriquement conducteur de l'espace débouchant au travers de l'au moins un passage (61, 62) du capot (6) de sorte à établir une continuité électrique entre le matériau électriquement conducteur et l'au moins un connecteur électrique (21,22), formant une reprise de contact (81, 82), le cordon de scellement (7) étant diélectrique.

2. Procédé selon la revendication précédente, dans lequel le au moins un passage (61, 62) du capot (6) est réalisé en regard du au moins un connecteur électrique (21, 22).

3. Procédé selon l'une des revendications précédentes, dans lequel l'étape de remplissage est configurée pour remplir intégralement l'espace débouchant et le au moins un passage (61, 62).

4. Procédé selon l'une des revendications précédentes, dans lequel le premier cordon de scellement (71) est configuré pour isoler au moins une partie de la surface supérieure du connecteur électrique (21, 22) relativement au reste du au moins un composant électronique (2).

5. Procédé selon l'une des revendications précédentes, dans lequel, préalablement à l'étape de remplissage par un matériau électriquement conducteur, on réalise dans le support (1) l'au moins un passage (63, 64) suivant une dimension en épaisseur dudit support de sorte à ce que l'au moins un passage (63, 64) traverse l'au moins un connecteur électrique (21, 22), et avantageusement dans lequel l'étape de remplissage est configurée de sorte à ce que le matériau conducteur traverse le support (1) au travers de l'au moins un passage (63, 64) de sorte à être exposé au niveau d'une deuxième face du support (1), opposée à la première face.

6. Procédé selon l'une quelconque des revendications précédentes, dans lequel l'étape de mise en place du capot (6) est configurée pour préserver au moins un deuxième accès à au moins un deuxième connecteur électrique (61, 62) ; ledit capot (6) comportant au moins un deuxième passage (61, 62) suivant une dimension en épaisseur du capot (6), et dans lequel l'étape de remplissage par un matériau conducteur est réalisée de sorte à remplir au moins le premier passage (61) formant une première reprise de contact (81) en continuité électrique avec le premier connecteur électrique (21) et le deuxième passage (62) formant une deuxième reprise de contact (82) en continuité électrique avec le deuxième connecteur électrique (22).

7. Procédé selon l'une quelconque des revendications précédentes, dans lequel le capot (6) comprend au moins un composant électronique (2) sur au moins l'une de ses faces et dans lequel l'au moins un passage (61, 62) du capot (6) traverse l'au moins un connecteur électrique (21, 22) du composant de sorte à ce que l'étape de remplissage soit configurée de sorte à établir une continuité électrique entre l'au moins un connecteur électrique (21, 22) d'un composant électronique (2) porté par le support (1) et l'au moins un connecteur électrique (21, 22) du composant électronique (2) porté par le capot (6).

8. Procédé selon l'une des revendications précédentes, dans lequel on superpose plusieurs dispositifs suivant la dimension en épaisseur, le capot (6) d'un premier dispositif faisant office de support (1) pour un deuxième dispositif, de sorte à ce que, lors de l'étape de remplissage, l'au moins un connecteur électrique (21, 22) de chacun des dispositifs soit mis en continuité électrique entre eux par le matériau conducteur de sorte à former une reprise de contact commune auxdits dispositifs (81, 82).

9. Procédé selon la revendication précédente, dans lequel au moins un passage (61, 62) de chaque dispositif est en regard d'un passage (61, 62) de chacun des autres dispositifs.

10. Procédé selon l'une quelconque des revendications précédentes, dans lequel le cordon de scellement (7) comprend un deuxième cordon (72) ; le deuxième cordon (72) formant un contour autour d'au moins une partie du composant.

11. Procédé selon l'une des revendications précédentes, dans lequel l'étape de remplissage comprend l'un parmi : une électrodéposition de couches conductrices, un laminage d'un film conducteur, un remplissage par un polymère en phase liquide ensuite solidifié.

12. Système électrique fabriqué selon le procédé de la revendication 1 en combinaison avec la revendication 3, comprenant au moins un dispositif comprenant sur une première face au moins un composant électronique (2) doté d'au moins un connecteur électrique (21, 22), le système comprenant :
- un capot (6) positionné au-dessus du composant (2) ; ledit capot (6) comportant au moins un passage (61, 62) suivant une dimension en épaisseur du capot (6) de sorte à former un accès à l'au moins un connecteur électrique (21, 22),
- un cordon de scellement (7) configuré de sorte que le composant (2) soit au moins en partie situé dans une cavité (9) délimitée par la première face du support (1), la première face du capot (6) et le cordon de scellement (7), le cordon de scellement comportant un premier cordon (71) au niveau de l'au moins un connecteur électrique (21, 22), le premier cordon (71) s'étendant autour de l'au moins un passage (61, 62) en un contour fermé formant une paroi pleine et continue délimitant latéralement un espace débouchant au travers de l'au moins un passage (61, 62) ;
le système comportant un matériau électriquement conducteur remplissant intégralement l'espace débouchant au travers de l'au moins un passage (61, 62) du capot (6) de sorte à établir une continuité électrique entre le matériau électriquement conducteur et l'au moins un connecteur électrique (21, 22), formant une reprise de contact (81, 82), le cordon de scellement (7) étant diélectrique, le matériau électriquement conducteur étant sous forme de couches conductrices électrodéposées ou d'un film conducteur laminé ou d'un polymère solidifié dans l'espace débouchant.

13. Système selon la revendication précédente, comprenant plusieurs dispositifs en superposition suivant la dimension en épaisseur; le capot (6) d'un premier dispositif formant le support (1) d'un deuxième dispositif, chacun des dispositifs comportant un passage (61, 62) de sorte à ce que, l'au moins un connecteur électrique (21, 22) de chacun des dispositifs soit mis en continuité électrique par le matériau conducteur formant une reprise de contact du système commune auxdits dispositifs (81, 82).

14. Système selon l'une quelconque des deux revendications précédentes, dans lequel le cordon de scellement (7) comprend un deuxième cordon (72) ; le deuxième cordon (72) formant un contour tout ou partie autour d'une partie du composant, une portion de l'au moins un connecteur électrique (21, 22) n'étant pas entouré par ledit deuxième cordon (72).

## Patentansprüche

1. Verfahren zur Herstellung eines elektrischen Systems, umfassend mindestens eine Vorrichtung, die eine Stütze (1) umfasst, die auf einer ersten Seite mindestens eine elektronische Komponente (2) trägt, die mit mindestens einem elektrischen Steckverbinder (21, 22) versehen ist, wobei das Verfahren umfasst:
- einen Schritt des Anbringens einer Abdeckung (6) über der Komponente, wobei die Abdeckung (6) mindestens einen Durchlass (61, 62) entlang einer Dickenabmessung der Abdeckung (6) derart beinhaltet, um einen Zugang zu dem mindesten einen elektrischen Steckverbinder (21, 22) zu bilden,
- einen Schritt des Bildens eines Versiegelungsbandes (7), derart, dass sich die Komponente mindestens teilweise in einem Hohlraum (9) befindet, der durch die erste Seite der Stütze (1), die erste Seite der Abdeckung (6) und das Versiegelungsband (7) begrenzt ist, wobei der Bildungsschritt konfiguriert ist, damit das Versiegelungsband (7) ein erstes Band (71) im Bereich des mindestens einen elektrischen Steckverbinders (21, 22) umfasst; wobei sich das erste Band (71) um den mindestens einen Durchlass (61, 62) herum in einer geschlossenen Kontur erstreckt, die eine volle und durchgehende Wand bildet, die seitlich einen Raum begrenzt, der durch den mindestens einen Durchlass (61, 62) mündet;
wobei das Verfahren einen Schritt des Füllens, der nach dem Bildungsschritt durchgeführt wird, des Raumes mit einem elektrisch leitfähigen Material umfasst, der durch den mindestens einen Durchlass (61, 62) der Abdeckung (6) mündet, um eine elektrische Kontinuität zwischen dem elektrisch leitfähigen Material und dem mindestens einen Steckverbinder (21, 22) aufzubauen, die eine Kontaktwiederaufnahme (81, 82) bildet, wobei das Versiegelungsband (7) dielektrisch ist.

2. Verfahren nach dem vorstehenden Anspruch, wobei der mindestens eine Durchlass (61, 62) der Abdeckung (6) gegenüber dem mindestens einen elektrischen Steckverbinder (21, 22) realisiert ist.

3. Verfahren nach einem der vorstehenden Ansprüche, wobei der Schritt des Füllens konfiguriert ist, um den mündenden Raum und den mindestens einen Durchlass (61, 62) vollständig zu füllen.

4. Verfahren nach einem der vorstehenden Ansprüche, wobei das erste Band (71) konfiguriert ist, um mindestens einen Teil der oberen Oberfläche des elektrischen Steckverbinders (21, 22) in Bezug auf den Rest der mindestens einen elektronischen Komponente (2) zu isolieren.

5. Verfahren nach einem der vorstehenden Ansprüche, wobei vor dem Schritt des Füllens mit einem elektrisch leitfähigen Material in der Stütze (1) mindestens ein Durchlass (63, 64) entlang einer Dickenabmessung der Stütze derart realisiert wird, dass der mindestens eine Durchlass (63, 64) den mindestens einen elektrischen Steckverbinder (21, 22) durchquert, und wobei der Schritt des Füllens vorteilhafterweise derart konfiguriert ist, dass das leitfähige Material die Stütze (1) durch den mindestens einen Durchlass (63, 64) hindurch durchquert, um im Bereich einer zweiten Seite der Stütze (1) entgegengesetzt zur ersten Seite offenliegt.

6. Verfahren nach einem der vorstehenden Ansprüche, wobei der Schritt des Anbringens einer Abdeckung (6) konfiguriert ist, um mindestens einen zweiten Zugang zu mindestens einem zweiten elektrischen Steckverbinder (61, 62) zu bewahren; wobei die Abdeckung (6) mindestens einen zweiten Durchlass (61, 62) entlang einer Dickenabmessung der Abdeckung (6) beinhaltet, und wobei der Füllschritt mit einem leitfähigen Material derart realisiert wird, um mindestens den ersten Durchlass (61) zu füllen, der eine erste Kontaktwiederaufnahme (81) in elektrischer Kontinuität mit dem ersten elektrischen Steckverbinder (21) bildet, und den zweiten Durchlass (62), der eine zweite Kontaktwiederaufnahme (82) in elektrischer Kontinuität mit dem zweiten elektrischen Steckverbinder (22) bildet.

7. Verfahren nach einem der vorstehenden Ansprüche, wobei die Abdeckung (6) mindestens eine elektronische Komponente (2) auf mindestens einer der Seiten umfasst, und wobei der mindestens eine Durchlass (61, 62) der Abdeckung (6) den mindestens einen elektrischen Steckverbinder (21, 22) der Komponente derart durchquert, dass der Füllschritt derart konfiguriert ist, um eine elektrische Kontinuität zwischen dem mindestens einen elektrischen Steckverbinder (21, 22) einer elektronischen Komponente (2), die von der Stütze (1) getragen wird, und dem mindestens einen elektrischen Steckverbinder (21, 22) der elektronischen Komponente (2), die von der Abdeckung (6) getragen wird, aufzubauen.

8. Verfahren nach einem der vorstehenden Ansprüche, wobei mehrere Vorrichtungen entlang der Dickenabmessung übereinandergestellt werden, wobei die Abdeckung (6) einer ersten Vorrichtung als Stütze (1) für eine zweite Vorrichtung genutzt wird, sodass beim Füllschritt der mindestens eine elektrische Steckverbinder (21, 22) jeder der Vorrichtungen durch das leitfähige Material in elektrische Kontinuität zueinander versetzt wird, um eine gemeinsame Kontaktwiederaufnahme der Vorrichtungen (81, 82) zu bilden.

9. Verfahren nach dem vorstehenden Anspruch, wobei mindestens ein Durchlass (61, 62) einer jeden Vorrichtung gegenüber einem Durchlass (61, 62) von jeder der anderen Vorrichtungen liegt.

10. Verfahren nach einem der vorstehenden Ansprüche, wobei das Versiegelungsband (7) ein zweites Band (72) umfasst; wobei das zweite Band (72) eine Kontur um mindestens einen Teil der Komponente bildet.

11. Verfahren nach einem der vorstehenden Ansprüche, wobei der Füllschritt eines umfasst aus: einer Elektroabscheidung von leitfähigen Schichten, eine Laminierung eines leitfähigen Films, ein Füllen mit einem Polymer in flüssiger und danach verfestigter Phase.

12. Elektrisches System, das gemäß dem Verfahren nach Anspruch 1 in Verbindung mit Anspruch 3 hergestellt worden ist, umfassend mindestens eine Vorrichtung, die auf einer ersten Seite mindestens eine elektronische Komponente (2) umfasst, die mit mindestens einem elektrischen Steckverbinder (21, 22) versehen ist, wobei das System umfasst:
- eine Abdeckung (6) über der Komponente (2) positioniert; wobei die Abdeckung (6) mindestens einen Durchlass (61, 62) entlang einer Dickenabmessung der Abdeckung (6) derart beinhaltet, um einen Zugang zu dem mindesten einen elektrischen Steckverbinder (21, 22) zu bilden,
- ein Versiegelungsband (7), derart konfiguriert, dass sich die Komponente (2) mindestens teilweise in einem Hohlraum (9) befindet, der durch die erste Seite der Stütze (1), die erste Seite der Abdeckung (6) und das Versiegelungsband (7) begrenzt ist, wobei das Versiegelungsband ein erstes Band (71) im Bereich des mindestens einen elektrischen Steckverbinders (21, 22) umfasst, wobei sich das erste Band (71) um den mindestens einen Durchlass (61, 62) herum in einer geschlossenen Kontur erstreckt, die eine volle und durchgehende Wand bildet, die seitlich einen Raum begrenzt, der durch den mindestens einen Durchlass (61, 62) mündet;
wobei das System ein elektrisch leitfähiges Material beinhaltet, das den Raum vollständig ausfüllt, der durch den mindestens einen Durchlass (61, 62) der Abdeckung (6) mündet, um eine elektrische Kontinuität zwischen dem elektrisch leitfähigen Material und dem mindestens einen elektrischen Steckverbinder (21, 22) aufzubauen, die eine Kontaktwiederaufnahme (81, 82) bildet, wobei das Versiegelungsband (7) dielektrisch ist, wobei das elektrisch leitfähige Material in Form von elektrisch abgeschiedenen leitfähigen Schichten oder eines laminierten leitfähigen Films oder eines Polymers in flüssiger und danach verfestigter Phase ist.

13. System nach dem vorstehenden Anspruch, mehrere übereinandergestellte Vorrichtungen entlang der Dickenabmessung umfassend; wobei die Abdeckung (6) einer ersten Vorrichtung die Stütze (1) für eine zweite Vorrichtung bildet, wobei jede der Vorrichtungen einen Durchlass (61, 62) beinhaltet, sodass der mindestens eine elektrische Steckverbinder (21, 22) jeder der Vorrichtungen durch das leitfähige Material, das eine Kontaktwiederaufnahme des gemeinsamen Systems der Vorrichtungen (81, 82) bildet, in elektrische Kontinuität versetzt wird.

14. System nach einem der beiden vorstehenden Ansprüche, wobei das Versiegelungsband (7) ein zweites Band (72) umfasst; wobei das zweite Band (72) eine Kontur um die gesamte oder mindestens einen Teil der Komponente bildet, wobei ein Abschnitt des mindestens einen elektrischen Steckverbinders (21, 22) nicht von dem zweiten Band (72) umgeben ist.

## Claims

1. Method for producing an electrical system comprising at least one device that comprises a support (1) carrying, on a first face, at least one electronic component (2) provided with at least one electrical connector (21, 22), the method comprising:
- a step of placing a cover (6) over the component, said cover (6) comprising at least one passage (61, 62) according to a dimension in thickness of the cover (6) so as to form an access to the at least one electrical connector (21, 22),
- a step of forming a sealing seam (7) such that the component is at least partially located inside a cavity (9) delimited by the first face of the support (1), the first face of the cover (6) and the sealing seam (7), said forming step being configured so that the sealing seam (7) comprises a first seam (71) at the at least one electrical connector (21, 22), the first seam (71) extending around the at least one passage (61, 62) in the form of a closed contour forming a continuous and solid wall laterally delimiting a through-space opening onto the at least one passage (61, 62);
the method comprising a step of filling, after the forming step, with an electrically conductive material, the through-space opening by means of the at least one passage (61, 62) of the cover (6) so as to establish electrical continuity between the electrically conductive material and the at least one electrical connector (21, 22), forming a tapping (81, 82), the sealing seam (7) being dielectric.

2. Method according to the preceding claim, wherein the at least one passage (61, 62) of the cover (6) is carried out facing the at least one electrical connector (21, 22).

3. Method according to one of the preceding claims, wherein the filling step is configured to completely fill the through-space and the at least one passage (61, 62).

4. Method according to one of the preceding claims, wherein the first sealing seam (71) is configured to insulate at least part of the upper surface of the electrical connector (21, 22) relatively from the rest of the at least one electronic component (2).

5. Method according to one of the preceding claims, wherein, prior to the step of filling with an electrically conductive material, the at least one passage (63, 64) is carried out in the support (1) according to a dimension in thickness of said support such that the at least one passage (63, 64) passes through the at least one electrical connector (21, 22), and advantageously wherein the filling step is configured such that the conductive material passes through the support (1) through the at least one passage (63, 64) such that it is exposed at a second face of the support (1), opposite the first face.

6. Method according to any one of the preceding claims, wherein the step of placing of the cover (6) is configured to preserve at least a second access to at least a second electrical connector (61, 62), said cover (6) comprising at least a second passage (61, 62) according to a dimension in thickness of the cover (6), and wherein the step of filling with a conductive material is carried out so as to fill at least the first passage (61), forming a first tapping (81) with electrical continuity with the first electrical connector (21) and the second passage (62), forming a second tapping (82) with electrical continuity with the second electrical connector (22).

7. Method according to any one of the preceding claims, wherein the cover (6) comprises at least one electronic component (2) on at least one of its faces, and wherein the at least one passage (61, 62) of the cover (6) passes through the at least one electrical connector (21, 22) of the component such that the filling step is configured so as to establish electrical continuity between the at least one electrical connector (21, 22) of an electronic component (2) carried by the support (1) and the at least one electrical connector (21, 22) of the electronic component (2) carried by the cover (6).

8. Method according to one of the preceding claims, wherein a plurality of devices are superimposed according to the dimension in thickness, the cover (6) of a first device acting as a support (1) for a second device, such that, during the filling step, the at least one electrical connectors (21, 22) of each of the devices is brought into electrical continuity with one another by the conductive material so as to form a tapping common to said devices (81, 82).

9. Method according to the preceding claim, wherein at least one passage (61, 62) of each device is facing a passage (61, 62) of each of the other devices.

10. Method according to any one of the preceding claims, wherein the sealing seam (7) comprises a second seam (72); the second seam (72) forming a contour around at least part of the component.

11. Method according to one of the preceding claims, wherein the filling step comprises one of the following: electrodeposition of conductive layers, lamination of a conductive film, filling with a liquid phase polymer then solidification.

12. Electrical system manufactured according to the method of claim 1 in combination with claim 3, comprising at least one device that comprises, on a first face, at least one electronic component (2) provided with at least one electrical connector (21, 22), the system comprising:
- a cover (6) positioned over the component (2), said cover (6) comprising at least one passage (61, 62) according to a dimension in thickness of the cover (6) so as to form an access to the at least one electrical connector (21, 22),
- a sealing seam (7) configured such that the component (2) is at least partially located inside a cavity (9) delimited by the first face of the support (1), by the first face of the cover (6) and by the sealing seam (7), the sealing seam comprising a first seam (71) at the at least one electrical connector (21, 22), the first seam (71) extending around the at least one passage (61, 62) in the form of a closed contour forming a continuous and solid wall laterally delimiting a through-space opening through the at least one passage (61, 62);
the system comprising an electrically conductive material completely filling the through-space opening by means of the at least one passage (61, 62) of the cover (6) so as to establish electrical continuity between the electrically conductive material and the at least one electrical connector (21, 22), forming a tapping (81, 82), the sealing seam (7) being dielectric, the electrically conductive material taking on the form of electrodeposited conductive layers or a laminated conductive film or a solidified polymer in the through-space.

13. System according to the preceding claim, comprising a plurality of devices superimposed according to the dimension in thickness; the cover (6) of a first device forming the support (1) of a second device, each of the devices comprising a passage (61, 62) such that the at least one electrical connector (21, 22) of each of the devices is brought into electrical continuity by the conductive material forming a tapping of the system common to said devices (81, 82)

14. System according to any one of the preceding two claims, wherein the sealing seam (7) comprises a second seam (72), the second seam (72) forming a contour wholly or partially around part of the component, a portion of the at least one electrical connector (21, 22) not being surrounded by said second seam (72).
